# EUROPEAN PATENT APPLICATION

(11) **EP 4 648 600 A1**
(43) Date of publication of application: **12.11.2025**
(21) Application number: 25168541.8
(22) Date of filing: 04.04.2025
(51) Int. Cl.: H10N 70/00, H10N 70/20

(54) **A FERROELECTRIC TUNNEL JUNCTION DEVICE AND MEMORY CELL**

(30) Priority: 08.05.2024 CN 202410560919
(71) Applicant: LoMaRe Technologies Limited, London Greater London EC3R 7LP (GB); LoMaRe Chip Technology Changzhou Co., Ltd., Changzhou City Jiangsu (CN)
(72) Inventor: ZEMEN, Jan, London, EC3R 7LP (GB); DOLUI, Kapildeb, London, EC3R 7LP (GB); ZOU, Bin, London, EC3R 7LP (GB); MIHAI, Andrei Paul, London, EC3R 7LP (GB)
(74) Representative: Mathys & Squire

(57) **Abstract**

Disclosed is a ferroelectric tunnel junction device (100), comprising a ferroelectric tunnel barrier layer (110); a first electrode layer (210) on one side of the ferroelectric tunnel barrier layer (110); a second electrode layer (220) on the other side of the ferroelectric tunnel barrier layer (110); and a first interfacial layer (212) at the interface between the first electrode layer (210) and the ferroelectric tunnel barrier layer (110). The first electrode layer (210) comprises a first antiperovskite material and the first interfacial layer (212) comprises a second antiperovskite material that differs from the first antiperovskite material in composition, and in at least the occupancy of corner sites or the centre sites. Also disclosed is a memory cell comprising the ferroelectric tunnel junction device (100), wherein the data is recordable as a direction of electric polarisation of the ferroelectric tunnel barrier layer (110).

## Description

### Technical Field

The invention relates generally to a ferroelectric tunnel junction device, preferably including perovskite-based electrode layer materials, and to a memory cell including the ferroelectric tunnel junction device.

### Background to the Invention

Established random access memory (RAM) technologies such as static RAM (SRAM) and dynamic RAM (DRAM) suffer from loss of data when disconnected from a power supply, i.e. volatility. Refreshing the state of RAM contributes to high energy consumption for data centres and modern computing in general. There is thus great interest in developing non-volatile RAM (NVRAM) technologies that are able to retain data even when disconnected from power. NVRAM technologies such as resistive RAM (ReRAM), phase change RAM (PC-RAM), magnetoresistive RAM (MRAM), and spin-transfer torque RAM (STT-RAM) have shown great promise as potential candidates for replacing conventional volatile RAM, like DRAM. However, these technologies also present several technical challenges related to scalability, endurance, power consumption and/or CMOS integrability.

Ferroelectric RAM (FeRAM) is an emerging NVRAM technology offering large ON/OFF ratios and fast read and write times together with lower power consumption compared to other NVRAM technologies that are current driven. FeRAM technology is based on ferroelectric tunnel junctions (FTJs), whereby information is encoded in the polarisation direction of a ferroelectric tunnel barrier layer sandwiched between two electrodes, which is switchable/reversible by applying an electric field between the electrodes.

Key performance metrics of FeRAM include the tunnelling electro-resistance (TER) and endurance (number of write cycles before the memory bit loses ferroelectricity and/or cannot be switched any more). The TER is a measure of the change in electrical resistance of the device associated with the reversal of the ferroelectric polarisation (i.e. the ON/OFF ratio) and should be maximized to improve dynamic range and readout of the memory bit. Research in this area to date has focussed on the choice of electrode materials and/or barrier materials to maximise the TER, with predicted ON/OFF ratios in certain FTJs already far exceeding those typically found in magnetic tunnel junctions. However, low endurance in FTJs caused mainly by oxygen diffusion from the ferroelectric tunnel barrier layer into the electrodes remains a significant problem to be addressed.

### Summary of the Invention

To overcome the above technical shortcomings in the prior art, the present invention provides a ferroelectric tunnel junction device with the aim of enhancing the TER while allowing for high endurance for non-volatile memory applications.

According to an aspect of the invention there is provided a ferroelectric tunnel junction (FTJ) device that is suitable for non-volatile memory applications. The device comprises a ferroelectric barrier layer, preferably having an electric polarization; a first electrode layer on one side of the ferroelectric barrier layer; a second electrode layer on the other side of the ferroelectric barrier layer; and a first interfacial layer at the interface between the first electrode layer and the ferroelectric barrier layer. Preferably the first electrode layer is formed/comprised of or comprises a first antiperovskite material and the first interfacial layer is formed/comprised of or comprises a second antiperovskite material that differs from the first antiperovskite material in its composition, preferably in at least an occupancy of corner sites or centre sites (of the antiperovskite crystal lattice of the respective layer). The first interfacial layer and the first electrode layer may form sublayers, or a part of, a first electrode layer, and/or the first interfacial layer may be referred to as an interfacial electrode layer or sublayer.

Generally, in an FTJ with two electrodes, the asymmetry of screening length of the field produced by the ferroelectric barrier layer results in a change of the electrical resistance of the FTJ when the ferroelectric polarization is switched. In addition to this asymmetric energy profile of the barrier layer, the resistance is dependent on the interfacial density of electronic states which also changes when the polarization is switched.

The first interfacial layer of the present invention can provide a means for tuning, through its composition (e.g. corner or centre site occupancy), the electronic states available for tunnelling at the electrode-barrier interface independently of the electronic properties of the first (bulk) electrode layer. This can effectively enhance the electronic properties of the electrode layer and gives an extra degree of freedom for engineering the tunnelling electroresistance (TER) (in addition to or instead of selecting a specific electrode material). Meanwhile, because the first interfacial layer and first electrode layer share the antiperovskite crystal lattice structure, they are essentially isostructural with minimal lattice mismatch, permitting high quality interfaces which means the robustness and endurance of the device is not compromised.

Specifically, the tunnelling current through the device is highly sensitive to the electronic properties at the electrode-barrier interfaces. The electric field from the ferroelectric barrier layer can penetrate a few atomic layers into the electrodes and change the population of the electronic band structure at the Fermi energy which is the origin of tunnelling electroresistance (TER). In general, maximising the TER requires goods mutual alignment of electronic states in k-space at the two electrode-barrier interfaces for one polarity of the ferroelectric barrier layer (the "ON" state of the device), and very poor alignment for the opposite polarity of the ferroelectric barrier layer (the "OFF" state of the device). In the present invention, this is achieved by the inclusion of a very thin isostructural interfacial layer in which the population of the electronic band structure is tuned by the occupancy of corner sites or centre sites of the antiperovskite crystal lattice to engineer the change of electronic states available for tunnelling induced by the change in polarization of the barrier layer. Changing the composition or occupation of corner/centre sites of the first (bulk) electrode layer can change the bulk lattice parameter and overall band structure, including the band structure of the barrier layer, which may be not desirable in certain cases (e.g. it may compromise the ferroelectric order of the barrier layer). However, when this is done in a sufficiently thin interfacial layer the occupation of the band structure, and the electronics states at the electrode-barrier interface can be tuned independently, without changing the lattice parameter or the band structure (because the lattice parameter and band structure in the interfacial layer follows that in the bulk electrode layer). Such antiperovskite materials with varying compositions and high crystallinity can be produced using CMOS compatible deposition methods, such as atomic layer deposition or magnetron sputtering.

In the context of the invention, the "occupancy" of the corner or centre sites refers to the proportion or fraction of respective lattice sites averaged over the layer that are occupied by a given element (e.g. ranging from 0 to 100%, or from 0 to 1 in the context of a compositional parameter), and/or the specific element occupying the respective lattice site. As such, the first interfacial layer may be an antiperovskite material having the same corner or centre site element as that in the first electrode layer but with a different fractional composition thereof, or the first interfacial layer may be an antiperovskite material having a different corner or centre site element to that of the first electrode layer, optionally also with a different fractional composition of the respective element. The corner and centre sites refer to lattice site locations in the ideal cubic antiperovskite unit cell as is known in the art, but it will be appreciated that this terminology applies also to cases where the antiperovskite unit cell is not in the ideal face centred cubic structure (e.g. octahedral distortion and tilting in the presence of strain).

In a preferred embodiment, the device is a non-volatile memory device, whereby the ferroelectric barrier layer serves as a storage layer in which data is recordable as a direction of electric polarisation of the ferroelectric material (which can be read out via the TER). In this case, the enhanced TER improves the dynamic range of the memory device, which in turn means more reliable and faster readout of the device state.

The first interfacial layer exhibits a different change in the electronic density of states (at the Fermi level) to the second electrode layer in response to a change in electric polarisation in the barrier layer.

Preferably, the first antiperovskite material and/or the second antiperovskite material is a metallic antiperovskite material. In this context, a "metallic" material means a material with no energy band gap. The use of metallic materials lowers the overall resistance of the device, contributing to lower power consumption of the device, and greater TER.

In various embodiments, the first antiperovskite material of the first electrode layer and/or the second antiperovskite material of the first interfacial layer are antiperovskite nitride materials. Preferably, both the first antiperovskite material and the second antiperovskite material are antiperovskite nitride materials. In this case, the first antiperovskite material of the first electrode layer and the second antiperovskite material of the first interfacial layer can take a number of forms including but not limiting to Cu and Mn-based antiperovskite nitrides.

The use of antiperovskite nitrides is advantageous for improving the endurance of the device, and particularly when used as a magnetic memory device, maintaining high spin polarisation of the electrodes at the interface (especially if there is nitride from both sides). Nitrides can be grown with high crystal quality. In FTJs, it is not so difficult to achieve high TER, but a significant challenge in their practical application is low endurance caused mainly by oxygen diffusion into the electrodes that can corrode the metallic electrode and form vacancies in the barrier. If the lattice structure of the electrode is the same as the barrier, the multilayer is more stable with respect to diffusion of small atoms across the interface.

In an embodiment, the first antiperovskite material of the first electrode layer is/comprises a Cu-based antiperovskite nitride of the form Cu₃A₁₋ₓN₁₋ᵤ and the second antiperovskite material of the first interfacial layer is/comprises a Cu-based antiperovskite nitride of the form Cu₃B_{1-y}N_{1-w}, wherein A and B are a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x ≤ 1, 0 ≤ y ≤ 1, 0 ≤ u < 1, 0 ≤ w < 1. Here x and y are compositional parameters that indicate the occupancy of the respective element. Preferably, A and B are the same element, in which case x ≠ y.

Preferably, the first antiperovskite material of the first electrode layer is formed/comprised of or comprises Cu₃PdN and the second antiperovskite material of the first interfacial layer is formed/comprised of or comprises Cu₃N.

In another embodiment, the first antiperovskite material of the first electrode layer is/comprises an Mn-based antiperovskite nitride of the form Mn₃₊ₓD₁₋ₓN₁₋ᵤ, and the second antiperovskite material of the first interfacial layer can be/comprise Mn-based antiperovskite nitride of the form Mn_{3+y}E_{1-y}N_{1-w} or a Cu-based antiperovskite nitride of the form Cu₃A_{1-z}N_{1-w}, wherein D and E are a corner site element selected from a group comprising: Ag, Al, Au, Co, Cu, Fe, Ga, Ge, In, Ir, Ni, Pd, Pt, Rh, Sb, Si, Sn, and Zn, wherein A is a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x ≤ 1, 0 ≤ y ≤ 1, 0 ≤ z ≤ 1, 0 ≤ u < 1, 0 ≤ w < 1. Again, x, y, and z are compositional parameters that indicate the occupancy of the respective element.

Preferably, the first antiperovskite material of the first electrode layer is formed/comprised of or comprises Mn₃GaN and the second antiperovskite material of the first interfacial layer is formed/comprised of or comprises Cu₃N.

Alternatively, where the first electrode layer and the first interfacial layer are both Mn-based antiperovskite nitrides, D and E are preferably the same element, in which case x ≠ y.

In a further embodiment, the first antiperovskite material of the first electrode layer and/or the second antiperovskite material of the first interfacial layer can have a nitrogen deficiency. In this case, the first antiperovskite material of the first electrode layer can be/comprise an antiperovskite nitride of the form M₃XN₁₋ₓ, and the second antiperovskite material of the first interfacial layer can be/comprise an antiperovskite nitride of the form M₃ZN_{1-y}, wherein M is a face-centre site element selected from a group comprising: Fe, Mn, Cu, and Ni, and X,Z is a corner site element selected from a group comprising: Sb, Pd, Rh, Ir, Ga, Ge, In, Mn, Pt, and Sn, and where 0 ≤ x < 1, 0 ≤ y < 1. Again, x and y are compositional parameters that indicate the occupancy of the respective element. Where X and Z are the same element, x ≠ y.

In another embodiment, the first antiperovskite material of the first electrode layer and/or the second antiperovskite material of the first interfacial layer can be an antiperovskite carbide material. Preferably, both the first antiperovskite materials and second antiperovskite materials are antiperovskite carbides. In this case, the first antiperovskite material of the first electrode layer can be/comprise an antiperovskite carbide of the form M₃XC₁₋ₓ, and the second antiperovskite material of the first interfacial layer can be/comprise an antiperovskite carbide of the form M₃ZC_{1-y}, wherein M is a face-centre site element selected from a group comprising: Co, Fe and Ni, and X and Z are a corner site element selected from a group comprising: Al, Ta, Ti, Ga, In, Mn, and Sn, and where 0 ≤ x <1, 0 ≤ y < 1. Where X and Z are the same element, x ≠ y.

The first interfacial layer may have a substantially uniform composition or occupancy of corner or centre sites in a direction perpendicular to the interface.

Preferably, the first interfacial layer may have a graded composition or occupancy of corner or centre sites in the direction perpendicular to the interface. In this context, the term "graded" means to vary in the direction perpendicular to the interface. The variation may be substantially smooth or gradual. A graded composition gives an extra degree of freedom to engineering the electronic properties of the electrode.

Preferably, the first interfacial layer has a thickness of 10 nm or less, or less than 5 nm, preferably less than 2 nm or less than 1 nm. The first interfacial layer has a thickness of at least a monolayer of the unit cell of the second antiperovskite material.

The ferroelectric barrier layer is a tunnel barrier comprised of an electrically insulating ferroelectric material. Preferably, the ferroelectric barrier layer is formed/comprised of or comprises a ferroelectric perovskite oxide material. Preferably, the space group of the ferroelectric barrier layer material, and the first antiperovskite material and second antiperovskite material are the same (space group 221 in the case of ideal cubic structure, or space group 123 if strained).

The use of a perovskite ferroelectric barrier layer in combination with the antiperovskite first electrode layer and the first interfacial layer is particularly advantageous as the compatibility of the lattice structures, sharing the same space group (space group 221 or space group 123 under strain), means they are substantially lattice matched and permits higher quality interfaces which in turn contributes to lower migration of oxygen anions into the first electrode layer and thereby to higher endurance of the device.

Preferably, the ferroelectric barrier layer may have a thickness of 10 nm or less, preferably less than 5 nm.

Preferably, a lattice mismatch between the barrier layer material, and the first antiperovskite material and second antiperovskite material is less than ±10%, preferably less than ±1%.

The ferroelectric perovskite material may in general have the form A'ₓA"₁₋ₓB'_{y}B"_{1-y}O₃, wherein A' and A" are one or more elements selected from a group comprising: Ca, Sr, Ba, Bi, Pb, La, and where B' and B" are one or more elements selected from a group comprising: Ti, Zr, Mo, W, Nb, Sn, Sb, In, Ga, Cr, Mn, Al, Co, Fe, Mg, Ni, Zn, Bi, Hf, Ta (not including any combinations which are not ferroelectric).

In a preferred embodiment, the ferroelectric perovskite material is formed/comprised of or comprises BaTiO₃.

The second electrode layer may be or comprise a metal, preferably Pt. Alternatively, the metal can be or comprise Au, Ag, Pd, Ir, or Rh. Such metals have a cubic lattice structure and thus pair well with perovskites.

Alternatively, the second electrode layer may be or comprise a third antiperovskite material, which is different to the first antiperovskite material and second antiperovskite material and/or exhibits a different change in the electronic density of states compared to the first interfacial layer in response to a change in polarization of the ferroelectric barrier layer.

In combination with a perovskite ferroelectric barrier layer, the use of antiperovskite materials for the first electrode layer, second electrode layer and the first interfacial layer is particularly advantageous for device endurance for similar reasons as explained above.

In an embodiment, the device comprises a second interfacial layer at the interface between the second electrode layer and the ferroelectric barrier layer, wherein the second interfacial layer is formed/comprised of or comprises a fourth antiperovskite material that differs from the third antiperovskite material in its composition, preferably in at least the occupancy of corner sites or centre sites (of the antiperovskite crystal lattice). The second interfacial layer and the second electrode layer may form sublayers or a part of a second electrode layer, and/or the second interfacial layer may be referred to as a further interfacial electrode layer.

This provides a means for independently engineering both electrode-barrier interfaces to tune and preferably maximise the TER. In particular, the population of the band structures in the first interfacial layer and the second interfacial layer can be tuned (independently), by their respective corner or centre site occupancies, to maximise the change in electronic states available for tunnelling in response to a change in polarisation in the ferroelectric barrier layer.

The antiperovskite materials of the first interfacial layer and second interfacial layer are preferably different, and/or exhibit a different change in the density of states in response to a change in electric polarisation in the ferroelectric barrier layer.

Preferably, the third antiperovskite material and/or the fourth antiperovskite material are metallic antiperovskite materials.

In an embodiment, the third antiperovskite material and/or the fourth antiperovskite material are antiperovskite nitride materials. Preferably, both the third antiperovskite material and the fourth antiperovskite material are antiperovskite nitride materials.

In an embodiment, the third antiperovskite material of the second electrode layer may be/comprise a Cu-based antiperovskite nitride of the form Cu₃A'_{1-x'}N_{1-u'} and the fourth antiperovskite material of the second interfacial layer may be/comprise a Cu-based antiperovskite nitride of the form Cu₃B'_{1-y'}N_{1-w'}, wherein A' and B' are a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x' ≤ 1, 0 ≤ y' ≤ 1, 0 ≤ u' < 1, 0 ≤ w' < 1. Here, x' and y' are compositional parameters that indicate the occupancy of the respective element.

Preferably A' and B' are the same element, in which case x' ≠ y'. In a preferred embodiment, the third antiperovskite material of the second electrode layer is formed/comprised or comprises Cu₃PdN and the fourth antiperovskite material of the second interfacial layer is formed/comprised of or comprises Cu₃N.

In another embodiment, the third antiperovskite material of the second electrode layer is/comprise a Mn-based antiperovskite nitride of the form Mn_{3+x'}D_{1-x'}N _{1-u'}, and the fourth antiperovskite material of the second interfacial layer is/comprise a Mn-based antiperovskite nitride of the form Mn_{3+y'}E'_{1-y}N_{1-w'} or a Cu-based antiperovskite nitride of the form Cu₃A'_{1-z'}N_{1-w'}, wherein D' and E' are a corner site element selected from a group comprising: Ag, Al, Au, Co, Cu, Fe, Ga, Ge, In, Ir, Ni, Pd, Pt, Rh, Sb, Si, Sn, and Zn, where A' is a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x' ≤ 1, 0 ≤ y' ≤ 1, 0 ≤ z' ≤ 1, 0 ≤ u' < 1, 0 ≤ w' < 1. Again, x', y', and z' are compositional parameters that indicate the occupancy of the respective element.

Preferably, the third antiperovskite material of the second electrode layer is formed/comprised of or comprises Mn₃GaN and the fourth antiperovskite material of the second interfacial layer is formed/comprised of or comprises Cu₃N.

Alternatively, where the second electrode layer and the second interfacial layer are both Mn-based antiperovskite nitrides, D' and E' are preferably the same element, in which case x' ≠ y'.

In a further embodiment, the third antiperovskite material of the second electrode layer and/or the fourth antiperovskite material of the second interfacial layer can be nitrogen deficient. In this case, the third antiperovskite material of the second electrode can be/comprise an antiperovskite nitride of the form M'₃X'N_{1-x'}, and the fourth antiperovskite material of the second interfacial layer can be/comprise an antiperovskite nitride of the form M'₃Z'N_{1-y'}, wherein M' is a face-centre site element selected from a group comprising: Fe, Mn, Cu, and Ni, and X',Z' is a corner site element selected from a group comprising: Sb, Pd, Rh, Ir, Ga, Ge, In, Mn, Pt, and Sn, and where 0 ≤ x' < 1, 0 ≤ y' < 1. Where X' and Z' are the same element, x' ≠ y'.

In an embodiment, the third antiperovskite material and/or the fourth antiperovskite material are antiperovskite carbide materials. Preferably, both the third antiperovskite material and the fourth antiperovskite material are antiperovskite carbide materials.

In this case, the third antiperovskite material of the second electrode layer can be/comprise an antiperovskite carbide of the form M'₃X'C_{1-x'}, and the fourth antiperovskite material of the further interfacial layer can be an antiperovskite carbide of the form M'₃Z**'**C_{1-y'}, wherein M' is a face-centre site element selected from a group comprising: Co, Fe and Ni, and X',Z' is a corner site element selected from a group comprising: Al, Ta, Ti, Ga, In, Mn, and Sn, and where 0 ≤ x' < 1, 0 ≤ y' < 1. Where X' and Z' are the same element, x' ≠ y'.

The second interfacial layer may have a substantially uniform occupancy of corner or centre sites in a direction perpendicular to the interface. Alternatively, the second interfacial layer may have a graded occupancy of corner or centre site atoms in the direction perpendicular to the interface.

Preferably, the second interfacial layer has a thickness of 10 nm or less, or less than 5 nm, preferably less than 2 nm or less than 1 nm. The second interfacial layer has a thickness of at least a monolayer of the unit cell of the fourth antiperovskite material.

Preferably, the space group of the ferroelectric barrier layer material, the first antiperovskite material and the second antiperovskite material, and the third antiperovskite material and the fourth antiperovskite material is the same (space group 221 in the case of an ideal cubic structure or space group 123 under strain).

Preferably, a lattice mismatch between the ferroelectric barrier layer material, and the third antiperovskite material and the fourth antiperovskite material is less than ±10%, preferably less than ±1%.

According to another aspect of the invention there is provided a memory cell or memory or memory array comprising the device of the first aspect, preferably wherein data or information is stored/recordable as a direction of electric polarisation of the ferroelectric barrier layer. The memory is preferably a non-volatile memory cell or memory.

Any device feature as described herein may also be provided as a method feature, and vice versa. As used herein, means plus function features may be expressed alternatively in terms of their corresponding structure. Any, some and/or all features in one aspect of the invention may be applied to other aspects of the invention, in any appropriate combination or sub-combination. In particular, device aspects may be applied to method aspects, and vice versa.

It should also be appreciated that particular combinations of the various features described and defined in any aspect of the invention can be implemented and/or supplied and/or used independently. The invention extends to methods, systems and devices substantially as herein described and/or as illustrated with reference to the accompanying figures. The invention also extends to any novel aspects or features described and/or illustrated herein.

In this specification the word 'or' can be interpreted in the exclusive or inclusive sense unless stated otherwise. Whilst the invention has been described in the context of memory, it can also be implemented in any field of use where a device with switchable resistance states is required, either on an individual scale or in a large-scale array of devices.

### Brief Description of Drawings

In order that the invention can be well understood, embodiments will now be discussed by way of example only with reference to the accompanying drawings, in which:
**Figures 1** is a schematic diagram of a ferroelectric tunnel junction device according to the prior art illustrating the principle of operation;
**Figure 2** shows an example cubic antiperovskite structure in the case of Cu₃PdN;
**Figure 3** is a schematic diagram of a ferroelectric tunnel junction device according to an embodiment of the present invention including a first interfacial layer on one side of the barrier layer;
**Figure 4** shows a schematic diagram of the variation in site occupancy with distance from the barrier;
**Figure 5** is a schematic diagram of a ferroelectric tunnel junction device according to another embodiment of the present invention including a first interfacial layer and a second interfacial layer on both sides of the barrier layer;
**Figure 6** shows a schematic diagram of a ferroelectric tunnel junction device according to another embodiment;
**Figure 7** shows the simulated density of states of the device structure of figure 6;
**Figure 8** shows the simulated transmission of the device structure of figure 6; and
**Figure 9** shows the simulated tunnelling electroresistance of the device of figure 6.

It should be noted that the figures are diagrammatic and may not be drawn to scale. Relative dimensions and proportions of parts of these figures may have been shown exaggerated or reduced in size, for the sake of clarity and convenience in the drawings. The same reference signs are generally used to refer to corresponding or similar features in modified and/or different embodiments.

### Detailed Description

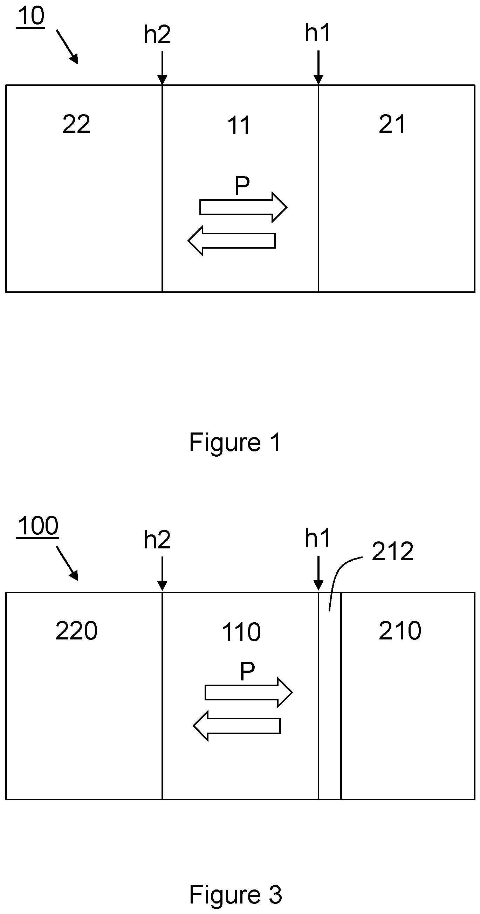

Figure 1 shows a schematic diagram of a conventional ferroelectric tunnel junction device 10 (FTJ) known in the art. The device 10 comprises a ferroelectric tunnel barrier layer 11 sandwiched between two electrodes layers 21, 22 formed of different electrode materials. The ferroelectric tunnel barrier layer 11 is sufficiently thin to exhibit quantum-mechanical tunnelling at low applied voltages, and exhibits a remnant ferroelectric polarisation P which can be switched between two directions (left and right in this example) by applying an electric field (voltage) between the electrodes 21, 22. The functionality of the device 10 is based on the dependence of the electrical resistance on the direction of polarisation P in the ferroelectric tunnel barrier layer 11, known as tunnelling electroresistance (TER) which can produce ON/OFF resistance ratios well in excess of 10³. This functionality, combined with the fact that the ferroelectric tunnel barrier layer 11 can retain its polarisation for long periods of time when disconnected from a power source makes the FTJ device 10 an attractive candidate for non-volatile memory whereby information is stored/encoded in the polarisation direction of a ferroelectric tunnel barrier layer 11 and can be read via the different resistances in the ON/OFF states.

The main origin of the TER effect is the polarisation-induced modulation of the electronic states at the electrode-barrier interfaces h1, h2 and the change in electrostatic potential profile of the tunnel barrier 11 itself (due to asymmetry of screening length in the electrodes) which in turn modulates the quantum-mechanical transmission through the barrier 11. The electric field from the ferroelectric barrier layer 11 can penetrate a few atomic layers into the electrodes 21, 22 and change the population of the electronic band structure at the Fermi energy which has a significant impact on the electronic states available for tunnelling through the barrier 11. A basic requirement for tunnelling through the barrier 11 is alignment in reciprocal k-space (kₓ, k_{y}) of filled electronic states in one electrode layer 21 and empty states in the other electrode layer 22. As such, in general, high TER requires good mutual alignment of electronic states in k-space (kₓ, k_{y}) at the two electrode-barrier interfaces h1, h2 for one polarity of the ferroelectric barrier layer 11 (the "ON" state of the device), and very poor alignment for the opposite polarity of the ferroelectric barrier layer 11 (the "OFF" state of the device). In practice, this generally requires an asymmetry between the two electrode-barrier interfaces h1, h2.

A common approach in the prior art is to use different materials for the two electrode layers 21, 22 which exhibit a different change in electronic properties or density of states with the polarisation of the barrier 11. Specific electrode materials can be chosen to exhibit a large response to the polarisation of the barrier 11.

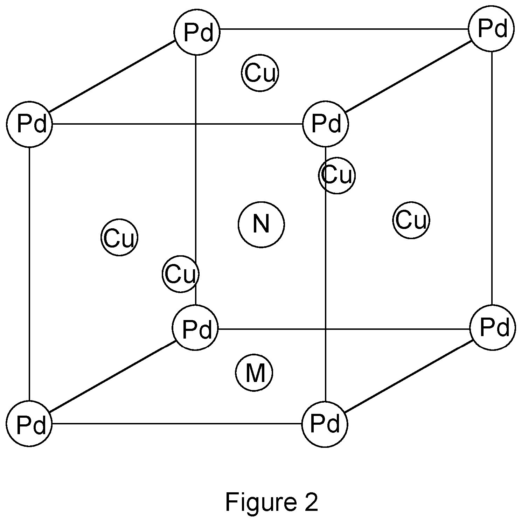

The present invention makes use of metallic antiperovskite electrode materials whose electronic (and magnetic) properties can be readily tuned through their composition and can be grown in ultrathin films with high crystalline quality. Antiperovskites are a family of alloys with a crystal structure similar to the perovskite structure which is cubic in the absence of strain, but with the positions of anion and cation constituent elements reversed in the unit cell. The antiperovskite structure is typically represented by the composition formula M₃BA, where M is a cation occupying the face-centre sites of the unit cell, B is an anion that occupies the corner sites of the unit cell, and A is an anion that occupies the body-centre site of the unit cell. Element A is usually Nitrogen (N) or Carbon (C), which are referred to herein as antiperovskite nitrides or carbides, respectively. Figure 2 illustrates the ideal cubic unit cell (in the absence of strain) of a Cu-based metallic antiperovskite, in this case Cu₃PdN. Other widely studied compositions include Mn₃GaN which is magnetic.

The fundamental insight of the present invention is to engineer the occupancy of corner sites or centre sites of the antiperovskite crystal lattice in a thin isostructural interfacial layer at one or both electrode-barrier interfaces to tune the population of the electronic band structure and achieve high sensitivity of the interfacial layer to the electric field produced by the ferroelectric barrier layer. The lattice structure does not change through the interfacial and electrode sublayers, but the occupancy of corner sites or centre sites can change layer by layer at the electrode-barrier interface. This gives an extra degree of freedom for engineering the TER beyond the selection of the bulk electrode materials themselves. As such, the interfacial layer forms an additional electrode layer or sublayer which enhances the electronic properties of the overall electrode. In this context, the "occupancy" of the corner or face centre sites or body centre sites refers to the proportion or fraction of respective lattice sites averaged over the layer that are occupied by a given element (e.g. ranging from 0 to 100%, or from 0 to 1 in the context of a compositional parameter), and/or the specific element occupying the respective lattice site. Where the body centre site element A is Nitrogen or Carbon, the material has a Nitrogen or Carbon deficiency if the occupancy of the body centre site is less than 1 or less than 100%.

Changing the composition or occupation of corner/centre sites of the whole electrode can change the bulk lattice parameter and the overall band structure, which may be not desirable in certain cases. However, when this is done in a sufficiently thin interfacial layer, as in the present invention, the occupation of the band structure and the electronics states at the electrode-barrier interface available for tunnelling can be tuned independently from the properties of the bulk electrode and without changing the lattice parameter or the band structure in the interfacial layer (because the lattice parameter and band structure in the thin interfacial layer follows that in the bulk electrode layer).

In contrast to doping (e.g. in materials such as semiconductors) which involves substituting elements in the lattice with impurities at relatively low concentrations compared to that of the bulk lattice elements, the approach of the present invention is based on removing elements from the lattice, whereby the concentration of corner/centre site elements in the interfacial layer is very high and can change layer-by-layer.

Figure 3 shows a schematic diagram of a ferroelectric tunnel junction device 100 (FTJ) according to an embodiment of the invention. The device 100 comprises a ferroelectric tunnel barrier layer 110 sandwiched between a first electrode layer 210 and a second electrode layer 220. The device 100 further comprises a thin first interfacial layer 212 at the interface h1 between the first electrode layer 210 and the barrier layer 110. The first electrode layer 210 comprises a first antiperovskite material and the first interfacial layer 212 comprises a second antiperovskite material that differs from the first antiperovskite material in at least the occupancy of corner sites or the centre sites to tune the electronic states at the electrode-barrier interface, as described above.

The first antiperovskite material and the second antiperovskite material are metallic (i.e. no band gap) and share the same lattice structure and space group, permitting high quality interfaces. The first electrode layer 210 and the first interfacial layer 212 form isostructural electrode sublayers of the device 100. The first electrode layer 210 is substantially thicker than the first interfacial layer 212 and can be considered a bulk electrode layer.

The first interfacial layer 212 has a thickness of at least one monolayer of the unit cell and less than 25 unit cells (the lattice parameter is approximately 0.4 nm). In practice, the first interfacial layer 212 will have a thickness of 10 nm or less, or less than 5 nm, preferably less than 2 nm or 1 nm.

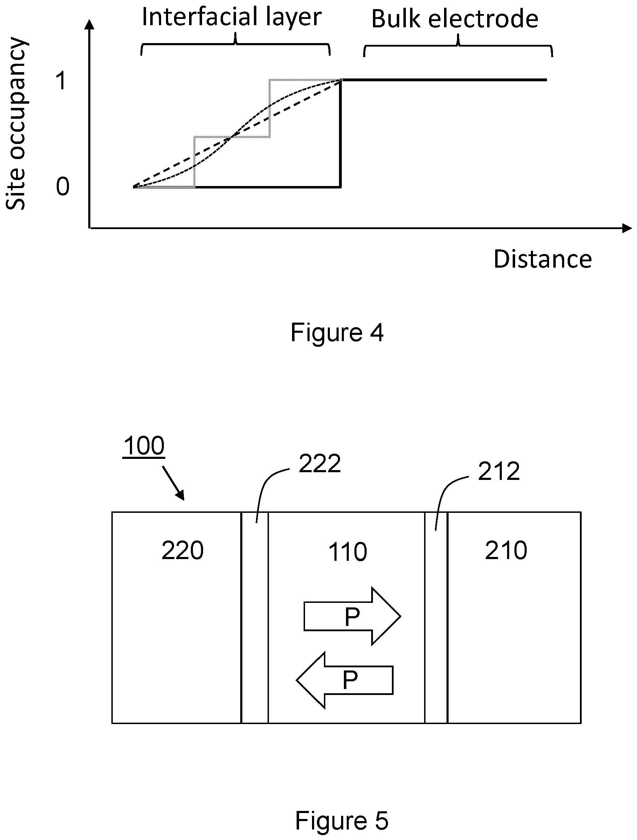

Figure 4 shows a schematic diagram illustrating the variation in the corner or centre site occupancy. Each individual site in the lattice can either be occupied by an element (occupancy of 1) or not occupied by an element (occupancy of 0). It will be appreciated that the occupancy or composition of the first electrode layer 210, the first interfacial layer 212 described herein refers to an average value over the respective layer volume which can vary (almost continuously) from 0 to 1 depending on the growth/deposition conditions, as is known in the art. The first interfacial layer 212 can have a substantially uniform occupancy of corner or centre sites in a direction perpendicular to the interface h1 with an abrupt change heterointerface as indicated by the bold line in figure 4, or a graded occupancy of corner or centre site atoms in the direction perpendicular to the interface which may be substantially smooth as indicated schematically by the dashed and dotted lines. In practice, because the first interfacial layer 212 is only a few monolayers thick, the variation in occupancy may be stepped, whereby the occupancy changes layer by layer (rather than a smooth transition), e.g. which is achievable by atomic layer deposition (ALD).

The ferroelectric barrier layer 110 preferably comprises a ferroelectric perovskite material, such as BaTiO₃ (BTO). The use of a perovskite ferroelectric barrier layer 110 in combination with the antiperovskite materials of the first interfacial layer 212 and the first electrode layer 210 is particularly advantageous from a manufacturability and performance perspective, as the compatibility of the lattice structures and lattice parameters, sharing the same space group (space group 221 or space group 123 under strain), means they are substantially lattice matched and permits higher quality interfaces which in turn contributes to lower migration of oxygen anions from the barrier layer 110 into the first electrode layer 210 and thereby to higher endurance of the device 100. Preferably, the lattice mismatch between the layers 110, 212, 210 is less than 10% and preferably less than 1%.

Preferably, the ferroelectric barrier layer 110 has a thickness of at least 1 nm and less than 10 nm, more preferably less than 5 nm. In practice, there is a balance between the ferroelectric barrier layer 110 needing to be sufficiently thick to ensure good ferroelectric behaviour and TER (and thus stability of data), but not too thick so as to overly limit the tunnel current through the device 100 (making reading and writing more difficult).

The second electrode layer 220 can be a metal, such as Pt, or another (third) metallic antiperovskite material. The use of an antiperovskite material in combination with the perovskite ferroelectric barrier layer 110 has the same advantages described above in terms of device endurance. It also allows for some tuning of the TER through its composition or occupancy of corner/centre sites. On the other hand, Pt is widely used in FTJs and CMOS processes and has a cubic lattice structure compatible with the perovskite barrier layer 110. The main requirement in this embodiment is that the second electrode layer 220 is a different material to the first interfacial layer 212, such that there is a different change in the electronic states available for tunnelling transport at the two electrode-barrier interfaces h1, h2.

The first interfacial layer 212 and first electrode layer 210 can be antiperovskite nitrides or carbides.

The choice of which site occupancy (i.e. corner, body centre, or face centre sites) to vary will depend on the parent compound. All three types of substitution can in principle tune the occupation of electronic states at Fermi level. The invention covers all three types of substitutions, and the below embodiments focus on substitutions that have been shown by the inventors or others to provide thermodynamically stable materials.

In a first example embodiment, the first interfacial layer 212 and first electrode layer 210 are comprised of Cu-based antiperovskite nitrides. In this case, the first electrode layer 210 is comprised of an antiperovskite nitride material of the form Cu₃A₁₋ₓN₁₋ᵤ, and the first interfacial layer 212 is comprised of an antiperovskite nitride material of the form Cu₃B_{1-y}N_{1-w}, wherein A and B are a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x ≤ 1, 0 ≤ y ≤ 1, 0 ≤ u < 1, 0 ≤ w < 1. Preferably, A and B are the same element in which case x ≠ y.

Further, in a specific example, the first electrode layer 210 is comprised of Cu₃PdN and the first interfacial layer 212 is comprised of Cu₃N. With reference again to figure 2, in this case the corner sites in the first interfacial layer 212 are not occupied, whereas the corner sites in the first electrode layer 210 are occupied with Pd. Cu₃PdN is a thermodynamically stable non-magnetic metallic antiperovskite nitride whose band structure and conductance can be varied through the Pd concentration during deposition. In particular, Cu₃N in bulk form (e.g. for thicknesses greater than 50 nm) is a semiconductor with a small band gap, but metallic in thin film form, as in the present case.

In a second example embodiment, the first electrode layer 210 is comprised of Mn-based antiperovskite nitride, and the first interfacial layer 212 can be comprised of a Cu-based antiperovskite nitride or a Mn-based antiperovskite nitride. In this case, the first electrode layer 210 is comprised of an antiperovskite nitride material of the form Mn₃₊ₓD₁₋ₓN₁₋ᵤ, and the first interfacial layer 212 is comprised of an antiperovskite nitride material of the form Mn_{3+y}E_{1-y}N_{1-w} or Cu₃A_{1-z}N_{1-w}, wherein D and E are a corner site element selected from a group comprising: Ag, Al, Au, Co, Cu, Fe, Ga, Ge, In, Ir, Ni, Pd, Pt, Rh, Sb, Si, Sn, and Zn, where A is a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x ≤ 1, 0 ≤ y ≤ 1, 0 ≤ z ≤ 1, 0 ≤ u < 1, 0 ≤ w < 1. Wherein D and E are the same element, x ≠ y.

Further, in a specific example, the first electrode layer 210 is comprised of Mn₃GaN and the first interfacial layer 212 is comprised of Cu₃N.

In a third example embodiment, the first electrode layer 210 is comprised of an antiperovskite nitride material of the form M₃XN₁₋ₓ, and the first interfacial layer 212 is comprised of an antiperovskite nitride of the form M₃ZN_{1-y}, wherein M is a face-centre site element selected from a group comprising: Fe, Mn, Cu, and Ni, and X,Z is a corner site element selected from a group comprising: Sb, Pd, Rh, Ir, Ga, Ge, In, Mn, Pt, and Sn, and where 0 ≤ x < 1, 0 ≤ y < 1. Where X and Z are the same element, x ≠ y.

As such, whereas in the first example embodiment and the second example embodiment the occupancy of the corner site is varied, in the third example embodiment the occupancy of the centre site can be varied by introducing a nitrogen deficiency.

In a fourth example embodiment, the first electrode layer 210 is comprised of an antiperovskite carbide of the form M₃XC₁₋ₓ, and the first interfacial layer 212 is comprised of an antiperovskite carbide of the form M₃ZC_{1-y}, wherein M is a face-centre site element selected from a group comprising: Co, Fe and Ni, and X,Z is a corner site element selected from a group comprising: Al, Ta, Ti, Ga, In, Mn, and Sn, and where 0 ≤ x < 1, 0 ≤ y < 1. Where X and Z are the same element, x ≠ y. Similar to above, in this example the occupancy of the centre site can be varied via by introducing a carbon deficiency.

Figure 5 shows a schematic diagram of a ferroelectric tunnel junction device 100 (FTJ) according to another embodiment of the invention. In addition to the features of the device 100 described above, the device 100 comprises a second interfacial layer 222 at the interface h2 between the second electrode layer 220 and the ferroelectric barrier layer 110. The second electrode layer 220 is comprised of a third antiperovskite material and the second interfacial layer 222 is comprised of a fourth antiperovskite material that differs from the third antiperovskite material in at least the occupancy of corner sites or the centre sites.

This embodiment provides additional control over the asymmetry of the electronic properties of the electrode-barrier interfaces h1, h2. It further provides an all-perovskite structure which, as described above, has advantages in terms of device interface quality, reproducibility and endurance.

The second antiperovskite material and the fourth antiperovskite material of the first interfacial layer 212 and the second interfacial layer 222 are different, such that there is a different change in the electronic states or density of states available for tunnelling transport at the two electrode-barrier interfaces h1, h2.

As with the embodiments described above, the third antiperovskite material and the fourth antiperovskite material are metallic and share the same lattice structure. Preferably, where a perovskite ferroelectric barrier layer 110 is used, all the layers of the device share the same space group with low lattice mismatch. Preferably, the lattice mismatch between the layers in the device 100 is less than 10% and more preferably less than 1 %. The second electrode layer 220 and the second interfacial layer 222 form isostructural electrode sublayers of the device 100. The second electrode layer 220 is substantially thicker than the second interfacial layer 222 and can be considered a bulk electrode layer. The second interfacial layer 222 has a thickness of at least one monolayer of the unit cell and less than 10 unit cells (preferably, less than 5 nm, more preferably less than 2 nm or 1 nm).

In example embodiments, the second interfacial layer 222 and second electrode layer 220 can be antiperovskite nitrides or carbides.

In a first example embodiment, the second interfacial layer 222 and second electrode layer 210 are comprised of Cu-based antiperovskite nitrides. In this case, the second electrode layer 210 is comprised of an antiperovskite nitride material of the form Cu₃A'_{1-x'}N_{1-u'}, and the second interfacial layer 222 is comprised of an antiperovskite nitride material of the form Cu₃B'_{1-y}N_{1-w}, wherein A' and B' are a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x' ≤ 1, 0 ≤ y' ≤ 1, 0 ≤ u' < 1, 0 ≤ w' < 1. Preferably, A' and B' are the same element in which case x' ≠ y'.

In a second example embodiment, the second electrode layer 220 is comprised of Mn-based antiperovskite nitride, and the second interfacial layer 222 can be comprised of a Cu-based antiperovskite nitride or a Mn-based antiperovskite nitride. In this case, the second electrode layer 220 is comprised of an antiperovskite nitride material of the form Mn_{3+x'}D_{1-x'}N_{1-u'}, and the second interfacial layer 222 is comprised of an antiperovskite nitride material of the form Mn_{3+y'}E'_{1-y'}N_{1-w'} or Cu₃A'_{1-z'}N_{1-w'}, wherein D' and E' are a corner site element selected from a group comprising: Ag, Al, Au, Co, Cu, Fe, Ga, Ge, In, Ir, Ni, Pd, Pt, Rh, Sb, Si, Sn, and Zn, where A' is a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x' ≤ 1, 0 ≤ y' ≤ 1, 0 ≤ z' ≤ 1, 0 ≤ u' < 1, 0 ≤ w' < 1. Wherein D' and E' are the same element, x' ≠ y'.

In a third example embodiment, the second electrode layer 220 is comprised of an antiperovskite nitride material of the form M'₃X'N_{1-x'}, and the second interfacial layer 222 is comprised of an antiperovskite nitride of the form M'₃Z'N_{1-y'}, wherein M' is a face-centre site element selected from a group comprising: Fe, Mn, Cu, and Ni, and X',Z' is a corner site element selected from a group comprising: Sb, Pd, Rh, Ir, Ga, Ge, In, Mn, Pt, and Sn, and where 0 ≤ x' < 1, 0 ≤ y' < 1. Where X' and Z' are the same element, x' ≠ y'. In this example, the occupancy of the centre site can be varied via by introducing a nitrogen deficiency.

In a fourth example embodiment, the second electrode layer 220 is comprised of an antiperovskite carbide of the form M'₃X'C_{1-x'}, and the second interfacial layer 222 is comprised of an antiperovskite carbide of the form M'₃Z**'**C_{1-y'}, wherein M' is a face-centre site element selected from a group comprising: Co, Fe and Ni, and X',Z' is a corner site element selected from a group comprising: Al, Ta, Ti, Ga, In, Mn, and Sn, and where 0 ≤ x' < 1, 0 ≤ y' < 1. Where X' and Z' are the same element, x' ≠ y'. Similar to above, in this example, the occupancy of the centre site can be varied via by introducing a carbon deficiency.

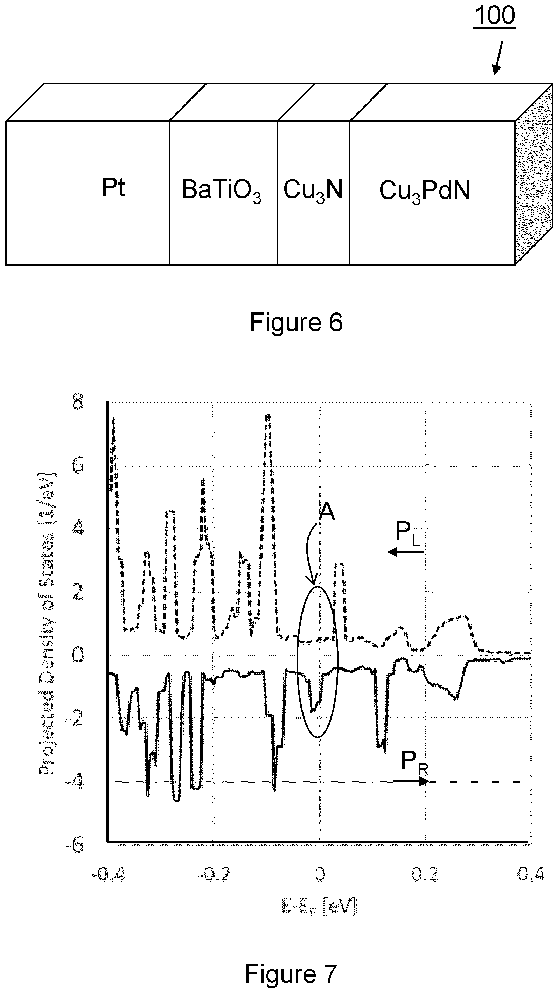

To illustrate the effect of the first interfacial layer 212 on the TER, simulations were performed of the example structure in figure 6 in which the second electrode layer 220 is comprised of Pt, the ferroelectric barrier layer 110 is comprised of BTO, the first interfacial layer 212 is comprised of two monolayers of Cu₃N, and the first electrode layer 210 is comprised of Cu₃PdN. The thickness of the BTO was 4.2 nm (10 unit cells) and the first interfacial layer 212 was two monolayers. In the simulation, the first interfacial layer 212 was terminated by a Cu-Cu-N layer at the interface h1 with the BTO barrier layer 110.

Simulations were performed using atomic-scale modeling tools from the QuantumATK package developed by Synopsys, in particular, Density Functional Theory (DFT) simulations with localized basis sets (LCAO - linear combination of atomic orbitals) were performed using the LDA exchange correlation potential and FHI-DZP basis set for calculation of the electronic structure. Transport properties were calculated using the formalism of non-equilibrium Green's functions (NEGF). These simulation techniques are described e.g. by Z. Dong et al. in "Tunneling current in HfO2 and Hf0.5Zr0.5O2 based ferroelectric tunnel junction", Journal of Applied Physics, Vol. 123, pp. 094501-094501 (2018), and by B. Nikolic et al. in "First-principles quantum transport modeling of spin-transfer and spin-orbit torques in magnetic multilayers." Handbook of Materials Modeling: Applications: Current and Emerging Materials (2020): 499-533.

Figure 7 shows the projected density of states of the Cu-Cu-N layer of the Cu₃N interfacial layer 212 which is in contact with the BTO barrier layer 110 as a function of energy for both polarisation states of the barrier layer 110. The dashed line shows the result for P_{L} pointing towards to the Pt electrode layer 220 and the solid line shows the result (mirrored about the energy axis for clarity) for P_{R} pointing towards to the Cu₃N interfacial layer 212. It can be seen from the region labelled A, that there is a significant difference in the density of states at and near the Fermi energy (E-E_{F}=0) where electronic transport takes place, which is indicative of a large TER.

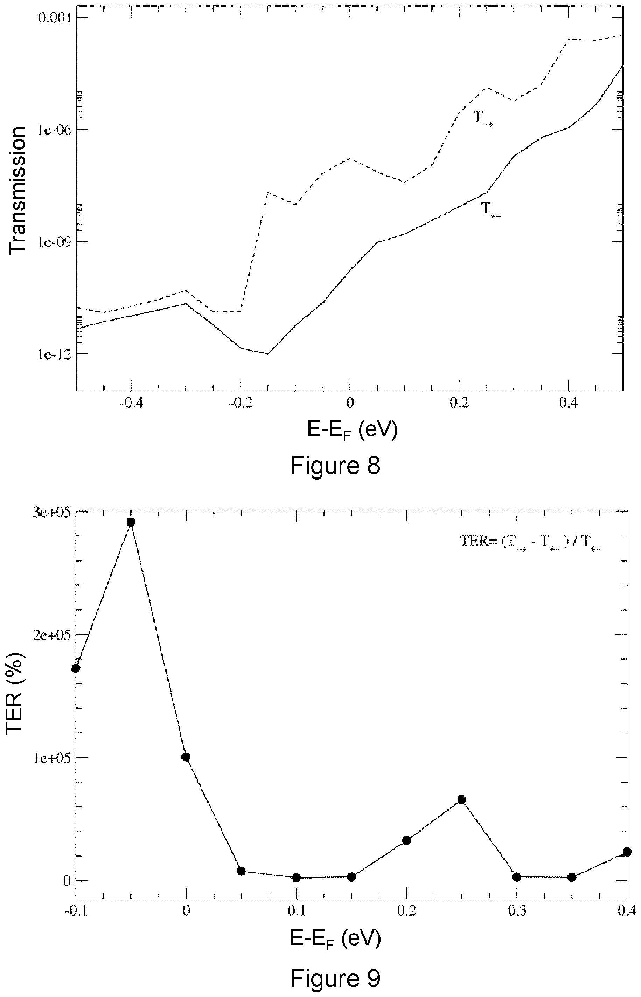

Figure 8 shows the calculated transmission T across the BTO barrier layer 110 as a function of energy for both polarisation states of the barrier layer 110 (T_{L} for P_{L} and T_{R} for P_{R}). Similarly, there is significant difference in transmission at and near the Fermi energy (E-E_{F}=0) indicative of a large TER.

Figure 9 shows the calculated TER for the structure as a function of energy, which is calculated as TER = (T_{R}-T_{L})/T_{L}. The calculated TER at the Fermi energy is approximately 1x10⁵ %. This is significantly greater than the corresponding calculated TER of approximately 3000 % for the same structure without the first interfacial layer 212. The simulation results thus demonstrate the advantages of incorporating an interfacial layer 212 at the electrode-barrier interface h1.

The invention thus provides an easily implementable new solution and an extra degree of freedom for engineering the transmission across the ferroelectric tunnel barrier layer 110, in addition to the selection of specific bulk electrode materials.

The multiple layers of the device 100 of the present invention can be manufactured using any suitable thin film deposition method, optimised for the required layers, thicknesses and materials. For example, atomic layer deposition (ALD), pulsed laser deposition (PLD), physical vapour deposition or magnetron sputtering (PVD), or a combination of different techniques can be used. In order to obtain a thin layer with the designed or varied composition/occupancy one can employ various methods. The most common approach is to co-sputter the elements from two targets (PVD) and control the power on one target while keeping other constant. In the case of Cu₃PdN the power on the Pd target is varied. Another approach is to grow a thin Cu₃N layer at the interface h1 with the barrier layer 110, e.g. usually under 1 monolayer, and then continue with a stoichiometric Cu₃PdN growth. To achieve atomically sharp and well-defined interfaces, it is necessary to control the temperature of the substrate to reduce the mobility of the adatoms so that the desired heterointerface is achieved In one example, suitable temperatures for deposition of stoichiometric Cu₃PdN are in the range between 100-400 °C, and should preferably be kept on the lower side to achieve a gradient at the interface with the barrier layer 110. In addition, the desired interface for a given material combination can be produced using PVD techniques through an iterative and empirical process of controlling the deposition conditions such as the interface that is presented to adatoms, substrate orientation, substrate temperature, pressure, and power, as is known in the art. Desired interfaces can also be produced using atomically controlled deposition techniques such as ALD.

By way of reference only, examples of the preparation of various perovskite and antiperovskite materials is provided below. Synthesis and engineering of antiperovskite/perovskite heterostructures is described, e.g. by C. Quintela et al. in "Epitaxial antiperovskite/perovskite heterostructures for materials design" Science Advances 6, 30 (2020). An example of the preparation of Mn₃GaN layers is described, e.g. by T Hajiri et al. in "Electrical current switching of the non-collinear antiferromagnet Mn3GaN" Applied Physical Letters 115, 05203 (2019). An example of the preparation of Mn₄N layers is described, e.g. by K. Ito et al. in "Perpendicular magnetic anisotropy in CoxMn4-xN (x=0 and 0.2) epitaxial films and possibly of tetragonal Mn4N phase" AlP Advances 6, 056201 (2016), and by J. Zeman in "Collinear and noncollinear ferrimagnetic phases in Mn4N investigated by magneto-optical Kerr spectroscopy" Journal of Applied Physics 134, 203902 (2023). An example of the preparation of Cu₃PdN and Cu₃N layers is described, e.g. by C. X. Quintela et al. in "Epitaxial thin films of Dirac semimetal antiperovskite Cu3PdN" APL Materials 5, 096103 (2017), and by A. Jiang et al. in "Preparation, structure, properties and application of copper nitride (Cu3N) thin films: A Review" Journal of Materials Science and Technology 34, 1467 (2018). An example of the preparation of SrTiO₃ and BaTiO₃ layers is described, e.g. by M. Vehkamaki et al. in "Growth of SrTiO3 and BaTiO3 Thin Films by Atomic Layer Deposition" Electrochemical and Solid State Letters 2, 504 (1999), and in I Marozau et al. in "One-step preparation of N-doped strontium titanate films by pulsed laser deposition" Applied Physics A 89, 933 (2007).

It will be understood that the present invention has been described above purely by way of example, and modifications of detail can be made within the scope of the invention defined in the claims. From reading the present disclosure, other variations and modifications will be apparent to the skilled person. Such variations and modifications may involve equivalent and other features which are already known in the art, and which may be used instead of, or in addition to, features already described herein. Any such modifications or equivalent changes and modifications made to the above embodiments based on the inventive concept of the present invention still fall within the scope of the present invention.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Each feature disclosed in the description, and (where appropriate) the claims and drawings may be provided independently or in any appropriate combination. Features which are described in the context of separate embodiments may also be provided in combination in a single embodiment. Conversely, various features which are, for brevity, described in the context of a single embodiment, may also be provided separately or in any suitable sub-combination. Reference numerals appearing in the claims are by way of illustration only and shall have no limiting effect on the scope of the claims.

## Claims

1. A ferroelectric tunnel junction device, comprising:
a ferroelectric tunnel barrier layer having an electric polarisation;
a first electrode layer on one side of the ferroelectric tunnel barrier layer;
a second electrode layer on the other side of the ferroelectric tunnel barrier layer; and
a first interfacial layer at the interface between the first electrode layer and the ferroelectric tunnel barrier layer,
wherein the first electrode layer comprises a first antiperovskite material and the first interfacial layer comprises a second antiperovskite material that differs from the first antiperovskite material in composition, and in at least the occupancy of corner sites or centre sites of the respective antiperovskite lattice.

2. The device of claim 1, wherein the first and/or second antiperovskite materials are metallic antiperovskite materials.

3. The device of claim 1 or 2, wherein the first and/or second antiperovskite materials are antiperovskite nitride materials or antiperovskite carbide materials.

4. The device of claim 1, 2 or 3, wherein the first antiperovskite material of the first electrode layer is an antiperovskite nitride of the form Cu₃A₁₋ₓN₁₋ᵤ and the second antiperovskite material of the first interfacial layer is an antiperovskite nitride of the form Cu₃B_{1-y}N_{1-w},
wherein A and B are a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x ≤ 1, 0 ≤ y ≤ 1, 0 ≤ u < 1, 0 ≤ w< 1.

5. The device of claim 4, wherein A and B are the same element and x ≠ y; and/or, wherein the first antiperovskite material comprises Cu₃PdN and the second antiperovskite material comprises Cu₃N.

6. The device of claim 1, 2 or 3, wherein the first antiperovskite material is an antiperovskite nitride of the form Mn₃₊ₓD₁₋ₓN₁₋ᵤ, and the second antiperovskite material is an antiperovskite nitride of the form Mn_{3+y}E_{1-y}N_{1-w} or Cu₃A_{1-z}N_{1-w},
wherein D and E are a corner site element selected from a group comprising: Ag, Al, Au, Co, Cu, Fe, Ga, Ge, In, Ir, Ni, Pd, Pt, Rh, Sb, Si, Sn, and Zn, where A is a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x ≤ 1, 0 ≤ y ≤ 1, 0 ≤ z ≤ 1, 0 ≤ u < 1, 0 ≤ w < 1.

7. The device of claim 6, wherein D and E are the same element and x ≠ y; and/or wherein the first antiperovskite material of the first electrode layer comprises Mn₃GaN and the second antiperovskite material of the first interfacial layer comprises Cu₃N.

8. The device of claim 1, 2 or 3, wherein the first antiperovskite material of the first electrode layer is or comprises:
(i) an antiperovskite carbide of the form M₃XC₁₋ₓ, and the second antiperovskite material of the first interfacial layer is an antiperovskite carbide of the form M₃ZC_{1-y}, wherein M is a face-centre site element selected from a group comprising: Co, Fe and Ni, and X,Z is a corner site element selected from a group comprising: Al, Ta, Ti, Ga, In, Mn, and Sn, and where 0 ≤ x < 1, 0 ≤ y < 1; or
(ii) an antiperovskite nitride of the form M₃XN₁₋ₓ, and the second antiperovskite material of the first interfacial layer is an antiperovskite nitride of the form M₃ZN_{1-y}, wherein M is a face-centre site element selected from a group comprising: Fe, Mn, Cu, and Ni, and X,Z is a corner site element selected from a group comprising: Sb, Pd, Rh, Ir, Ga, Ge, In, Mn, Pt, and Sn, and where 0 ≤ x < 1, 0 ≤ y < 1.

9. The device of any preceding claim, wherein the first interfacial layer has:
a substantially uniform occupancy of corner or centre sites in a direction perpendicular to the interface, or a graded occupancy of corner or centre site atoms in the direction perpendicular to the interface; and/or
a thickness of 10nm or less.

10. The device of any preceding claim, wherein the ferroelectric tunnel barrier layer comprises a ferroelectric perovskite material; and, optionally or preferably,
wherein the ferroelectric perovskite material of the ferroelectric tunnel barrier layer has the form A'ₓA"₁₋ₓB'_{y}B"_{1-y}O₃, wherein A' and A" are one or more elements selected from a group comprising: Ca, Sr, Ba, Bi, Pb, and La, and where B' and B" are one or more elements selected from a group comprising: Ti, Zr, Mo, W, Nb, Sn, Sb, In, Ga, Cr, Mn, Al, Co, Fe, Mg, Ni, Zn, Bi, Hf, and Ta; and more preferably,
wherein the ferroelectric perovskite material is or comprises BaTiO₃.

11. The device of any preceding claim, wherein the second electrode layer comprises: a third antiperovskite material; and/or a metallic material, preferably Pt.

12. The device of claim 11, comprising a second interfacial layer at the interface between the second electrode layer and the ferroelectric tunnel barrier layer,
wherein the second interfacial layer comprises fourth antiperovskite material that differs from the third antiperovskite material in composition, and in at least the occupancy of corner sites or centre sites of the respective antiperovskite lattice; and, optionally or preferably,
wherein the third antiperovskite material and/or fourth antiperovskite material comprise: metallic antiperovskite materials; and/or antiperovskite nitride materials or antiperovskite carbide materials.

13. The device of claim 12, wherein the third antiperovskite material of the second electrode layer is or comprises:
(i) an antiperovskite nitride of the form Cu₃A'_{1-x'}N_{1-u'} and the fourth antiperovskite material of the second interfacial layer is an antiperovskite nitride of the form Cu₃B'_{1-y}N_{1-w}, wherein A' and B' are a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x' ≤ 1, 0 ≤ y' ≤ 1, 0 ≤ u' < 1, 0 ≤ w' < 1; and, optionally or preferably,
wherein A' and B' are the same element and x' ≠ y', and/or wherein the third antiperovskite material of the second electrode layer comprises Cu₃PdN, and the fourth antiperovskite material of the second interfacial layer comprises Cu₃N; or
(ii) an antiperovskite nitride of the form Mn_{3+x'}D_{1-x'}N_{1-u'}, and the fourth antiperovskite material of the second interfacial layer is an antiperovskite nitride of the form Mn_{3+y'}E'_{1-y}N_{1-w'} or Cu₃A'_{1-z'}N_{1-w'}, wherein D' and E' are a corner site element selected from a group comprising: Ag, Al, Au, Co, Cu, Fe, Ga, Ge, In, Ir, Ni, Pd, Pt, Rh, Sb, Si, Sn, and Zn, where A' is a corner site element selected from a group comprising: Pd, Ru, Cu, Rh, Ag, Al, Au, Co, Cu, Fe, Ga, Ge, In, Ir, Mn, Ni, Pt, Sb, Si, Sn, and Zn, and where 0 ≤ x' ≤ 1, 0 ≤ y' ≤ 1, 0 ≤ z' ≤ 1, 0 ≤ u' < 1, 0 ≤ w' < 1; and, optionally or preferably,
wherein D' and E' are the same element and x' ≠ y', and/or wherein the third antiperovskite material of the second electrode layer comprises Mn₃GaN, and the fourth antiperovskite material of the second interfacial layer comprises Cu₃N.

14. The device of claim 12, wherein the third antiperovskite material of the second electrode layer is or comprises:
(i) an antiperovskite carbide of the form M'₃X'C_{1-x'}, and the fourth antiperovskite material of the second interfacial layer is an antiperovskite carbide of the form M'₃Z**'**C_{1-y'},
wherein M' is a face-centre site element selected from a group comprising: Co, Fe and Ni, and X',Z' is a corner site element selected from a group comprising: Al, Ta, Ti, Ga, In, Mn, and Sn, and where 0 ≤ x' < 1, 0 ≤ y' < 1; or
(ii) an antiperovskite nitride of the form M'₃X'N_{1-x'}, and the fourth antiperovskite material of the second interfacial layer is an antiperovskite nitride of the form M'₃Z'N_{1-y'},
wherein M' is a face-centre site element selected from a group comprising: Fe, Mn, Cu, and Ni, and X',Z' is a corner site element selected from a group comprising: Sb, Pd, Rh, Ir, Ga, Ge, In, Mn, Pt, and Sn, and where 0 ≤ x' < 1, 0 ≤ y' < 1.

15. A memory cell comprising the device of any of claims 1 to 14, wherein data is recordable as a direction of electric polarisation of the ferroelectric tunnel barrier layer.
